(19) Europäisches Patentamt
European Patent Office
Office européen des brevets

(11) **EP 4 418 405 A1**

(12) **EUROPEAN PATENT APPLICATION**

(43) Date of publication:
**21.08.2024 Bulletin 2024/34**

(21) Application number: **23156524.3**

(22) Date of filing: **14.02.2023**

(51) International Patent Classification (IPC):
**H01M 10/48** (2006.01) **H01M 50/569** (2021.01)
**H01M 10/42** (2006.01) **G01R 31/36** (2020.01)

(52) Cooperative Patent Classification (CPC):
**H01M 10/48; G01R 31/367; G01R 31/392;
H01M 10/4285; H01M 50/569**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **TWAICE Technologies GmbH
80807 München (DE)**

(72) Inventor: **SINGER, Jan
81371 München (DE)**

(74) Representative: **Kraus & Lederer PartGmbB
Thomas-Wimmer-Ring 15
80539 München (DE)**

(54) **STATE OF HEALTH AND INITIAL PRESSURE OF BATTERY CELL**

(57) Various examples of the disclosure generally pertain to predicting the state of health of the battery cell depending on an initial pressure of the battery cell. Various examples relate to building a respective forecast model that enables to make such prediction. The forecast model can be empirically determined.

## FIG. 7

EP 4 418 405 A1

# EP 4 418 405 A1

**Description**

TECHNICAL FIELD

Various examples of the disclosure relate to techniques for characterizing a battery. In particular, various examples of the invention relate to techniques for forecasting state of health of a battery cell depending on a pressure applied to the battery cell.

BACKGROUND

Rechargeable batteries such as lithium-ion batteries (LIBs) are the main choice of power source for portable electronics, grid energy storage systems, and electric vehicles. LIBs are also widely used in stationary energy storage, e.g., in connection with photovoltaic power plants.

According to various formats of battery cells, e.g., pouch, prismatic, or cylindrical, battery cells are constrained with a fixed force or arranged in a fixed housing during manufacturing. An initial cell pressure or strain or stress is applied either by the housing or clamping plates to ensure a good performance of battery cells.

It has been observed that the state of health of the battery during its lifetime depends on the initial pressure of a battery cell.

SUMMARY

Therefore, there is a need for improved techniques of characterizing rechargeable batteries. In particular, there is a need for techniques that enable to reliably and accurately predict the state of health of battery cells of a rechargeable battery.

This need is met by the features of the independent claims. The features of the dependent claims define embodiments.

Various examples of the disclosure generally pertain to predicting the state of health of the battery cell depending on an initial pressure of the battery cell. Various examples relate to building a respective forecast model that enables to make such prediction. The forecast model can be empirically determined.

A method of characterizing ageing of a battery cell of a rechargeable battery as disclosed. The method includes clamping the battery cells such that an initial internal pressure of the battery cell is set. The method also includes obtaining, over a lifetime of the battery cell, a set of values for a state of health of the battery cell and an associated set of internal pressure changes relative to the initial pressure. The method also includes determining, based on the set of values for the state of health and the set of internal pressure changes, and ageing factor defining an impact of the initial internal pressure on a degradation of the state of health over the lifetime.

The obtaining of the set of values for a state of health of the battery and the determining of the ageing factor can be executed by at least one processor of a computing device upon loading respective program code from a memory and upon executing the program code.

A computer-implemented method of predicting ageing of a battery cell includes obtaining a predetermined model describing an evolution of the state of health of the battery cell over its lifetime depending on an initial pressure of the battery cell and as a function of one or more stress factors. The method also includes predicting a decrease of the state of health over the lifetime depending on a load profile that specifies the one or more stress factors over the lifetime.

A computer program includes program code. The program code can be loaded by at least one processor. The at least one processor can execute the program code. The at least one processor, upon executing the program code, performs a method of predicting ageing of a battery cell. The method includes obtaining a predetermined model describing an evolution of the state of health of the battery cell over its lifetime depending on an initial pressure of the battery cell and as a function of one or more stress factors. The method also includes predicting a decrease of the state of health over the lifetime depending on a load profile that specifies the one or more stress factors over the lifetime.

A computing device includes the at least one processor and the memory.

It is to be understood that the features mentioned above and those yet to be explained below may be used not only in the respective combinations indicated, but also in other combinations or in isolation without departing from the scope of the invention.

BRIEF DESCRIPTION OF THE DRAWINGS

FIG. 1 is a flowchart of an example method.

2

FIG. 2 schematically illustrates a measurement set up for measuring an internal pressure of the battery cell across its lifetime according to various examples.

FIG. 3 illustrates degradation of the state of health associated with capacity over the lifetime of a battery for multiple initial internal pressures of a battery cell.

FIG. 4 illustrates degradation of the state of health associated with impedance/resistance over the lifetime of a battery for multiple initial internal pressures of a battery cell.

FIG. 5 illustrates an increase of the internal pressure of a battery cell over the lifetime of the battery cell.

FIG. 6 illustrates pressure fluctuations of the internal pressure of the battery cell due to charging and discharging for multiple initial internal pressures.

FIG. 7 is a processing pipeline of forecasting a state of health under consideration of an initial internal pressure and a pressure fluctuation of a battery cell.

FIG. 8 schematically illustrates a processing device according to various examples.

FIG. 9 is a flowchart of an example method.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Battery cells are breathing and swelling over their lifetime. A volume change and resulting pressure change be dangerous for safety and stability of the battery. At the least, it can influence the cell performance. Systems designer thus aim to understand and forecast the pressure evolution of the lifetime of a battery cell. Systems design also aim to understand how the initial pressure applied to the battery cell - e.g., due to its housing into a battery cell casing - will affect the state of health of the battery.

Hereinafter, techniques related to finding a correlation between state of health of the battery cell and internal pressure of the battery cell are disclosed. As a general rule, the state of health can be the state of health associated with fade fate or impedance growth. Accordingly, a correlation between capacity of the battery cell (relative reduction of the capacity with respect to an initial capacity) and the internal pressure of the battery can be determined according to techniques disclosed herein. Alternatively or additionally, a correlation between impedance/resistance of the battery cell (relative growth of the impedance with respect to an initial impedance) and the internal pressure of the battery can be determined.

Specifically, it is possible to predict an impact of an initial pressure applied to the battery cell on the state of health. The initial internal pressure is conventionally defined by the housing of the battery cell. Different form factors or dimensions of a battery cell can result in different initial internal pressures. Thus, it is helpful to understand the impact of a particular design of the housing of the battery cell on the performance of the battery cell.

Techniques related to a forecast model predicting the state of health over the lifetime of the battery are disclosed. This means that the evolution of the state of health over the lifetime can be determined depending on the initial internal pressure. Along with this, the evolution of the internal pressure over the lifetime can be predicted. The forecast model can be empirically determined, i.e., based on measurements.

A workflow from lab data generation, parameter fit of functions and equations towards the model application is disclosed.

The techniques described herein can be used in connection with a wide range of different battery types, for example in connection with lithium-ion-based batteries, such as lithium-nickel-manganese-cobalt oxide batteries or lithium-manganese-oxide batteries. Other examples include sodium ion batteries.

The batteries described herein can be used in various applications, for example for batteries used in devices such as motor vehicles or drones or portable electronic devices such as mobile phones. It would also be possible to use the batteries described herein in the form of stationary energy storage devices.

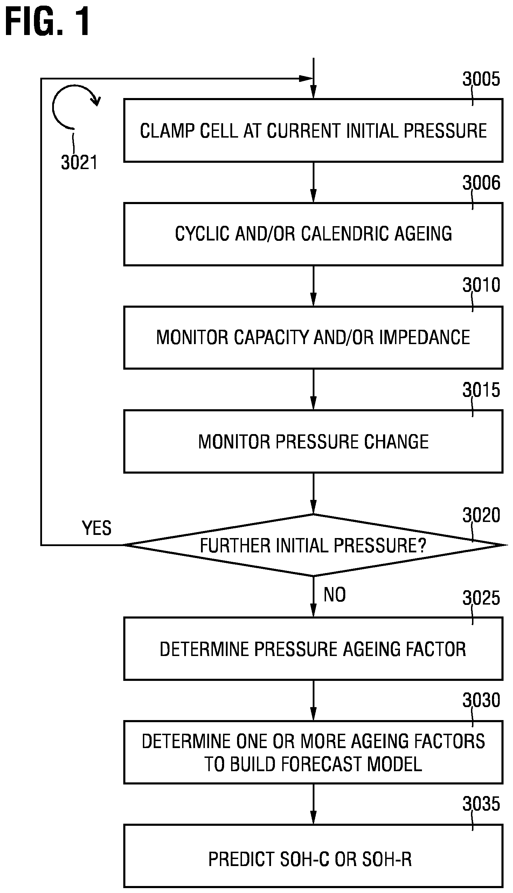

FIG. 1 is a flowchart of a method according to various examples. The method of FIG. 1 enables characterizing ageing of a battery cell.

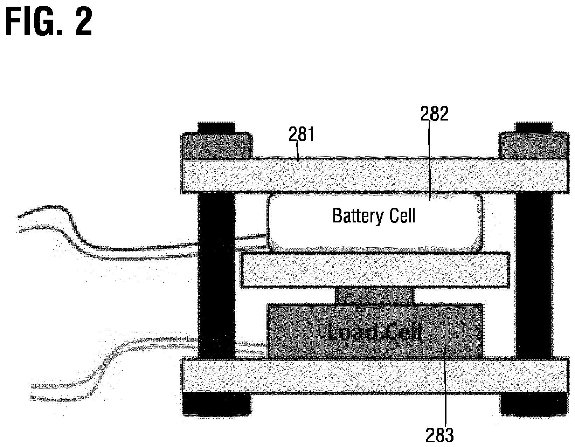

At box 3005, a battery cell (a test cell) of a rechargeable battery is clamped such that an initial pressure of the battery cell is set to a certain value. This is a laboratory measurement. A respective measurement set-up as illustrated in FIG. 2. See Cannarella, John, and Craig B. Arnold. "Stress evolution and capacity fade in constrained lithium-ion pouch cells." Journal of Power Sources 245 (2014): 745-751. A clamping system 281 applies an adjustable initial pressure (denoted $P_1$, $P_2$, $P_3$ hereinafter) to a battery cell 282. A sensor 283 measures the pressure. The pressure measured by the sensor 283 changes over the lifetime of the battery. There are different options to measure the pressure at the battery cell. For instance, load cells can be used. Micro-electromechanical pressure sensors can be employed.

Referring again to FIG. 1: at box 3006, cyclic and/or calendric ageing of the battery cell is then enforced. This can include charging/discharging cycles or allowing the battery cell to rest. The temperature can be fixed. The volume of the battery cell can be fixed (cf. FIG. 2). The cyclic and/or calendric ageing of the battery cell is enforced over the lifetime of the battery cell. Here, "lifetime" means a significant fraction of the overall service period of the battery. For instance, the state of charge can degrade of health can degrade from 100% to 70% over the lifetime.

In general, accelerated testing of batteries may be conducted as a means to assess whether a battery will meet its life cycle requirements. Such accelerated testing may be conducted by elevating at least one of battery stress factors to increase the degradation rate and precipitate failure earlier than under normal operation.

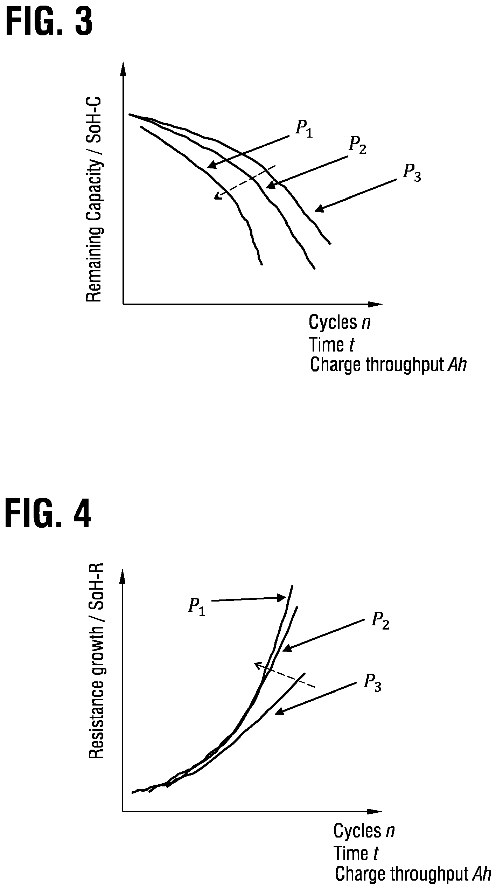

At box 3010, the capacity fade and resistance growth is measured over the lifetime of the battery. Thereby, a set of values for the state of health of the battery is obtained. The respective capacity fade is illustrated in FIG. 3 for multiple different initial pressures $P_{init} = P_1, P_2, P_3$. The resistance growth over lifetime is illustrated in FIG. 4 for the multiple different initial pressures $P_{init} = P_1, P_2, P_3$. Here, $P_1 > P_2 > P_3$. I.e., ageing of the battery progresses faster for larger initial internal pressures of the battery cell.

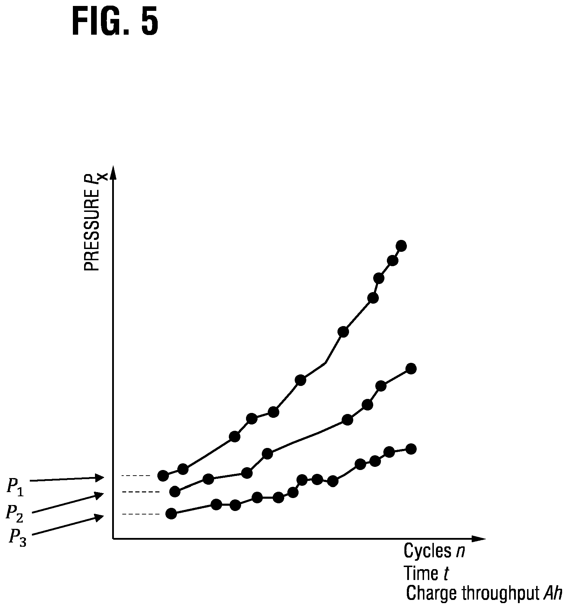

Referring again to FIG. 1: Also, at box 3015, pressure changes of the internal pressure of the test cell are monitored/tracked over time (and accordingly as a function of state of health). This is illustrated in FIG. 5. Beyond this general dependency of the internal pressure of the battery cell on lifetime, also the pressure fluctuation due to charging/discharging for each individual charging cycle can be recorded.

Referring again to FIG. 1: At box 3020 it is determined whether a set of the state of health values and associated internal pressure changes of the battery cell are to be obtained for a further initial pressure. If yes, boxes 3005, 3010, and 3015 are re-executed for a further initial pressure (e.g.., FIG. 3 and FIG. 4 illustrate three initial pressures $P_{init} = P_1$, $P_2, P_3$); in a further iteration 3021.

Once all sets of values of the SOH-parameter and the internal pressure have been collected, at box 3025, an ageing factor is determined. The ageing factor correlates the state of health with the initial internal pressure. The ageing factor defines an impact of the initial internal pressure on the degradation of the state of health over the lifetime. For instance, the larger (smaller) the ageing factor, the stronger (weaker) the degradation of the state of health over the lifetime.

The determining at box 3025 is based on the respective set of values tracked for the parameter associated with the state of health in each iteration 3021; as well as the set of internal pressure changes determined in each iteration 3021. The ageing factor can be determined by as one of multiple fitting parameters ("free parameters") of a predetermined parametrized function that describes the evolution (change of) of the state of health over the lifetime.

The parameterized function can model an exponential dependency of the state of health on pressure change. The exponential dependency is only one option and other dependencies would be possible, e.g., polynomial dependencies.

An example parameterized function is given below:

$$\Delta SoH_C \propto -c_P^{\frac{P_x - P_{\text{init}}}{\Delta P}} \sqrt{t}$$

$$\Delta SoH_R \propto c_P^{\frac{P_x - P_{\text{init}}}{\Delta P}} \sqrt{t}$$

(1)

Here, t indicates increasing lifetime. As a general rule, while herein various dependencies are disclosed for time (i.e., calendric ageing), similar dependencies can be formulated based on cycles $n$ or charge throughput A$h$. Increasing time t can be substituted by increasing cycle count $n$ or charge throughput A$h$ageingageing.

$P_{\text{init}}$ is the initial internal pressures and are hence known (e.g., $P_{\text{init}} = P_1, P_2, P_3$).

$P_x$ is the internal pressure of the battery cell during the lifetime. $P_x = P_x(t)$.

In Equation 1, $c_p$ is the ageing factor due to changes in the pressure. The ageing factor $c_p$ describes the relative ageing due to changes in the pressure of the battery cell, for different initial internal pressures of the battery cell. Here, $0 \leq c_p \leq 1$. The ageing factor correlates changes of the state of health with changes of the pressure.

The pressure ageing factor, accordingly, indicates an acceleration of the decrease of the state of health caused by an increase of the internal pressure of the battery cell relative to the initial internal pressure (given by $P_x$ - $P_{\text{init}}$).

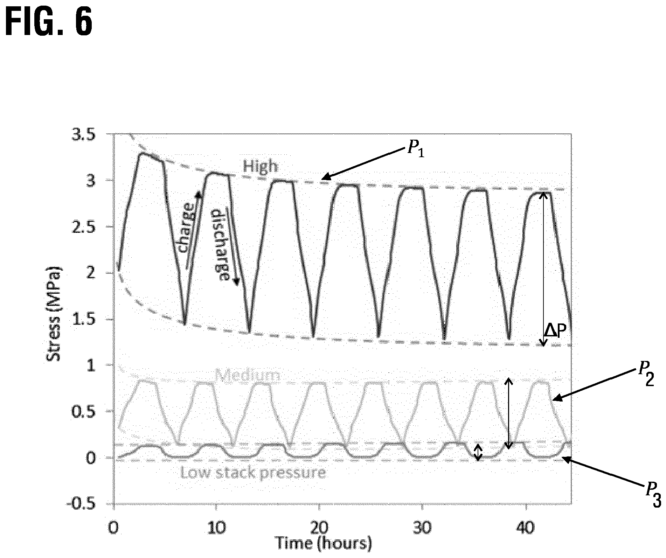

This is normalized by the pressure fluctuation $\Delta P$ due to charging and discharging. This pressure fluctuation depends on the initial internal pressure, i.e., $\Delta P = \Delta P(P_{\text{init}})$. $\Delta P$ is the pressure change between fully charged and fully discharged. The respective pressure change is illustrated in FIG. 6 for initial cycling of the battery, e.g., as measured in box 3015. See Cannarella, John, and Craig B. Arnold. "Stress evolution and capacity fade in constrained lithium-ion pouch cells." Journal of Power Sources 245 (2014): 745-751. As shown in FIG. 6, the pressure fluctuation increases for larger internal pressures, i.e., $\Delta P(P_1) > \Delta P(P_2) > \Delta P(P_3)$.

For larger initial internal pressures, accordingly, the denominator of the exponent of the predetermined function of Eq. 1 is increased; and, accordingly, the impact of any given pressure change on the state of health is amplified.

Thus, ageing is expected to progress faster for larger initial internal pressures. This is also illustrated in FIG. 3 and FIG. 4 by the dashed arrows. As illustrated in FIG. 3 and FIG. 4, for larger internal pressures ($P_1 > P_2 > P_3$), the decrease of the state of charge is accelerated.

Thus, the ageing factor indicates the acceleration of the decrease of the state of health for changes of the internal pressure of the battery cell (relative to the initial internal pressure) and normalized with respect to a pressure fluctuation due to charging and discharging.

The left-hand side of equation 1 is known based on the measurements of capacity and/or resistance (cf. FIG. 3 and FIG. 4). Also, $P_{\text{init}}$ is known and $P_x$ is measured. Thus, it is possible to fit the exponential function(s) of Equation 1 to the measured dependencies of $\Delta SOC_C$, $R$ on $P_{\text{init}}$ - $P_x$ and $\Delta P$, to thereby obtain the ageing factor $c_p$.

Thus, based on the techniques disclosed above, the relative ageing ($\Delta SOC$) due to changes in the internal pressure ($P_x$ - $P_{\text{init}}$) of the battery cell can be determined.

Sometimes, it can be desirable to obtain an absolute ageing, i.e., to quantify the state of health.

For this, one or more further aging factors can be determined at box 3030 and a respective forecast model can be built based on the pressure aging factor of box 3025, as well as the one or more further aging factors determined at box 3030.

Further ageing factors can, in particular, model the impact of changes of the battery voltage (open-circuit voltage) and temperature with respect to associated initial values on the state of health. Also, another ageing factor is an additional proportionality coefficient $c_a$ is considered. This proportionality coefficient is indicative of the rate of the ageing of the battery cell depending on one or more stress factors. Based on this proportionality coefficient and the pressure ageing coefficient $c_p$, as well as voltage ageing coefficient $c_V$ and temperature ageing coefficient $c_T$, a forecast model can be built to determine the state of health in absolute terms:

$$\text{SoH}_C = 1 - c_a c_V^{\frac{V-V_{\text{init}}}{\Delta V}} c_T^{\frac{T-T_{\text{init}}}{\Delta T}} c_P^{\frac{P_x-P_{\text{init}}}{\Delta P}} \sqrt{t}$$

$$\text{SoH}_R = 1 + c_a c_V^{\frac{V-V_{\text{init}}}{\Delta V}} c_T^{\frac{T-T_{\text{init}}}{\Delta T}} c_P^{\frac{P_x-P_{\text{init}}}{\Delta P}} \sqrt{t}$$

(2)

In Equation 2, $c_V$ is the ageing factor that describes the ageing due to voltage changes of the battery cell. $c_T$ is the ageing factor that describes the ageing due to temperature changes of the battery cell. V is the (open-circuit) voltage of the battery cell; Vinit is the initial voltage of the battery cell; and $\Delta V$ is the change of the voltage between charging and discharging of the battery cell. T is the temperature of the battery cell; Tinit is the initial temperature; and $\Delta V$ is the change of the temperature between charging and discharging. The determination of $c_V$ and $c_T$ is out of scope of this application (but can be implemented with comparable measurements as the one explained in FIG. 2 for $c_P$).

It is possible to determine the proportionality coefficient $c_a$ for various stress factors such as state of charge, stepped of discharge, C-Rate, temperature. I.e., $c_a = c_a(\text{SOC,DOD,T,C-Rate})$. The determination of this coefficient at box 3030 is out of scope of the subject disclosure (respective test setups, e.g., for fixed pressure, fixed volume, etc. are known to the skilled person).

Generally, SoC is defined as the ratio of battery remaining capacity to its nominal capacity. The SoC is a value between 0% and 100% that indicates the relative level of charge presently held by the battery. The units of SoC are percentage points. A SoC of 100% corresponds to a "full" battery, while a SoC of 0% corresponds to an "empty" battery.

The DoD may be defined as the maximum fraction or percentage of a battery's capacity (given in Ah) which is removed from the charged battery in a discharging process or on a regular basis. "Charged" does not necessarily refer to fully or 100 % charged, but rather to the SoC, where the battery charger stops charging. The DoD can also be defined as the fraction or percentage of the battery's capacity which is currently removed from the battery with regard to its (fully) charged state. For fully charged batteries, the DoD is connected to the SoC by the formula *DoD* = 100% - *SoC*. The DoD then is the complement of the SoC: as one increases, the other decreases.

Charge and discharge rates of a battery are governed by C-rates. The capacity of a battery is commonly rated at 1C, meaning that a fully charged battery rated at 1 Ampere hour (Ah) should provide 1A for one hour. The same battery discharging at 0.5C should provide 500 milliamperes (mA) for two hours, and at 2C it delivers 2A for 30 minutes. A C-rate of 1C is also known as a one-hour discharge; 0.5C or C/2 is a two-hour discharge and 0.2C or C/5 is a 5-hour discharge. Some high-performance batteries can be charged and discharged above 1C with moderate stress.

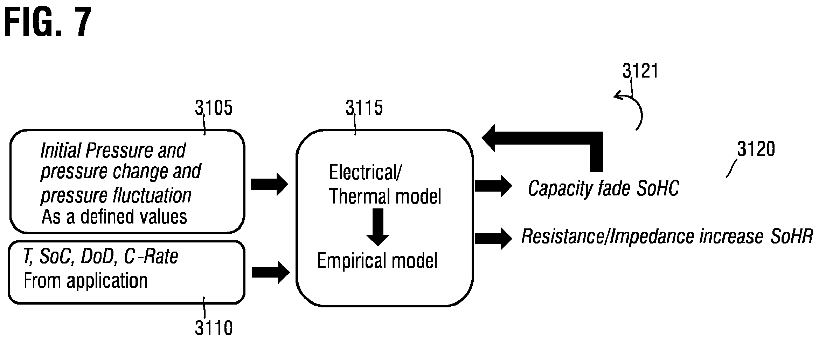

It is then optionally possible, at box 3035, to employ the forecast model for ageing prediction. For instance, battery cells of the same type can be modeled. A respective processing pipeline is illustrated in FIG. 7.

FIG. 7 illustrates aspects with respect to forecasting the state of health of a battery depending on a respective forecast model. The forecast model is determined in box 3035 can be used.

In FIG. 7, it is illustrated that the initial internal pressure $P_{\text{init}}$ and pressure fluctuation $\Delta P$ and the internal pressure evolution over lifetime $P(t)$ (alternatively over charging-discharging cycles or charge throughput) are obtained as parameters at box 3105 for the prediction. This is typically a battery-specific parameter set, e.g., depending on the particular geometry and dimensioning of the battery cells.

At box 3110, temperature, state of charge, depth of discharge, and C-rate are obtained for a prediction interval. This is specified by a load profile. Such stress factors depend on the use case. For instance, such stress factors will take different values for a mobility use case - e.g., using battery cells as traction batteries of an electric vehicle - then for a stationary energy storage use case - e.g., for buffering electric energy created using renewable energies.

These stress factors can be predefined in accordance with the use case. It would also be possible that respective stress factors are obtained from field-deployed batteries based on reports from the battery management system.

At box 3115, based on an electrical model in a thermal model of the battery, it is possible to calculate the evolution of voltage and the temperature over the battery cell's lifetime, e.g., as a function of time, charge throughput and/or charging/discharging cycles. Thus, temperature and voltage can be input into the empirical model of Eq. 1 (along with the initial pressure and pressure change and pressure evolution over lifetime of box 3105) and the output is then the prediction of the capacity state of health and/or the impedance/resistance state of health at box 3120. It is possible to use a rolling determination that includes multiple iterations 3221. Here, the calculated state of healths are fed back to box 3115 for each iteration. The calculated state of healths (or generally at least one of capacity fade or resistance increase) are usedto update the electrical and thermal models used in box 3115. For the next iteration of the rolling determination, a more accurate prediction of voltage and temperatur is thereby obtained. Thus, a rolling prediction where the state of health is predicted in time / charge throughput / charging-discharging increments (corresponding to the iterations 3121) and for the next iteration the electrical and thermal models are adjusted based on the adjusted state of health can be employed.

The electric model can be used to determine the open circuit voltage at the battery cell. For instance, respective techniques are disclosed in DE 10 2021 105 784 A1, the respective disclosure being incorporated herein in its entirety. An equivalent circuit model may be used.

An electrical model and a thermal model that can be employed for the subject application are disclosed in Rohr, Stephan, et al. "Quantifying uncertainties in reusing lithium-ion batteries from electric vehicles." Procedia Manufacturing 8 (2017): 603-610.

An electrical model that can be used for the subject application is disclosed in Baumann, Michael, Stephan Rohr, and Markus Lienkamp. "Cloud-connected battery management for decision making on second-life of electric vehicle batteries." 2018 Thirteenth International Conference on Ecological Vehicles and Renewable Energies (EVER). IEEE, 2018.

Furthermore, a thermal model is considered that can be used to determine the internal temperature at one or more battery cells. Respective techniques are disclosed, e.g., in US 2022/0374568 A1. The disclosure is incorporated herein in its entirety.

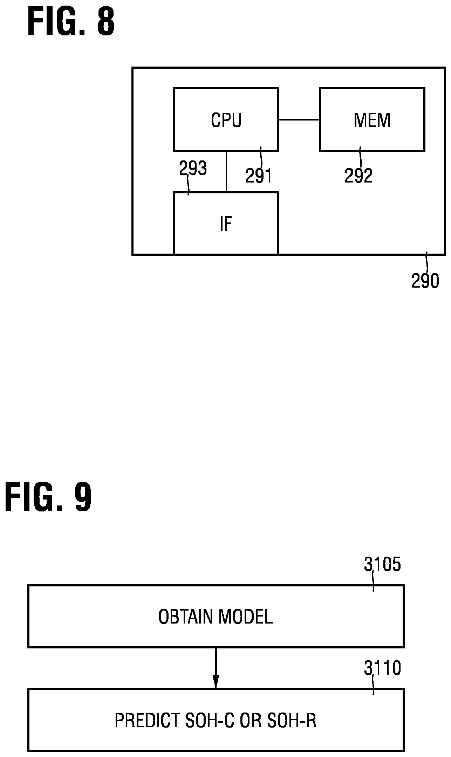

FIG. 8 illustrates a processing device 290. The processing device 290 includes a processor 291 and a memory 292. The processor 291 can load program code from the memory 292. The processor 291 can then execute the program code. The processor, upon executing the program code, can perform techniques as disclosed herein, e.g.: applying fits to measurement data to determine coefficients of a model of the state of health over the lifetime of a battery cells; applying a forecast model to predict the state of health over the lifetime; For example, the processor 292, upon executing the program code, can execute the method of FIG. 7 or execute box 3025, box 3030, or box 3035.

FIG. 9 is a flowchart of a method according to various examples. The method of FIG. 9 can be executed by a processor upon loading program code from a memory and upon executing the program code. The method of FIG. 9 can be executed by the processor 291 upon loading and executing program code stored in the memory 292.

The method of FIG. 9 relates to predicting a state of health of a battery over its lifetime. The state of health of the battery can be predicted using a forecast model that is empirically determined. The forecast model can be determined as described above in connection with box 3030.

The forecast model can provide the state of health as a function of time, charge throughput, and/or count of charge/discharge cycles. The forecast model can include an aging proportionality factor that lengths the state of health to one or more stress factors such as state of charge or depth of discharge. The forecast model can include multiple aging factors respectively linking voltage, temperature, and pressure to the state of health.

Box 3110 then corresponds to box 3035. The prediction can be implemented using the processing illustrated in FIG. 7. Using such techniques, it is, in particular, possible to predict the state of health over the lifetime of the battery depending on different initial clamping pressures of the battery cell. Thereby, system designers can predict how different system integration form factors of a battery cell will relate to performance of the battery in terms of state of health.

While above a prediction of the state of health has been disclosed, similar techniques can also be used to estimate the state of health based on a load profile of stress factors that is obtained from a field-deployed battery at box 3110.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

Above, various scenarios have been disclosed in connection with an initial pressure of a battery cell. The initial pressure correlates with strain or stress of the battery cell such that strain or stress equate to pressure.

**Claims**

**1.** A method of characterizing ageing of a battery cell (282) of a rechargeable battery, the method comprising:

- clamping (3005) the battery cell such that an initial internal pressure of the battery cell (282) is set;
- obtaining (3010), over a lifetime of the battery cell, a set of values for a state of health of the battery cell and an associated set of internal pressure changes relative to the initial internal pressure;
- determining (3025), based on the set of values for the state of health and the set of internal pressure changes, an ageing factor defining an impact of the initial internal pressure on a degradation of the state of health over the lifetime.

**2.** The method of claim 1,

wherein the ageing factor indicates an acceleration of the decrease of the state of health caused by an increase of an internal pressure of the battery cell relative to the initial internal pressure.

3. The method of claim 2,
wherein the ageing factor indicates the acceleration of the decrease of the state of health caused by the increase of the internal pressure of the battery cell relative to the initial internal pressure and normalized with respect to a pressure fluctuation due to charging and discharging.

4. The method of any one of the preceding claims,
wherein the ageing factor is determined as a fitting parameter of a predetermined parameterized function describing an evolution of the state of health over the lifetime.

5. The method of claim 4,
wherein the predetermined parameterized function describes the evolution of the state of health as a function of a change of the internal pressure of the battery cell.

6. The method of claim 5,
wherein the predetermined parameterized function describes an exponential dependency of the state of health on the change of the internal pressure of the battery cell.

7. The method of any of the preceding claims, further comprising:

   - obtaining a proportionality coefficient associated with the state of health; and
   - determining, based on the ageing factor and the proportionality coefficient, a forecast model describing an evolution of the state of health over the lifetime.

8. The method of claim 7,
wherein the ageing factor depends on one or more stress factors.

9. The method of claim 7 or 8, further comprising:

   - employing the forecast model to predict the evolution of the state of health over the lifetime of a further battery cell.

10. A computer-implemented method of predicting ageing of a battery cell, the method comprising:

   - obtaining a predetermined model describing an evolution of the state of health of the battery cell over its lifetime depending on an initial internal pressure of the battery cell and as a function of one or more stress factors, and
   - predicting (3115) a decrease of the state of health over the lifetime depending on a load profile specifying the one or more stress factors over the lifetime.

11. The computer-implemented method of claim 10,

   wherein inputs of the predetermined model comprise: a pressure evolution over the lifetime; a temperature evolution over the lifetime; and a voltage evolution over the lifetime,
   wherein the pressure evolution is predetermined,
   wherein the temperature evolution is determined based on a thermal model of the battery cell,
   wherein the voltage evolution is determined based on an electrical model of the battery cell.

12. The computer-implemented method of claim 11,

   wherein the decrease of the state of health over the lifetime is predicted using a rolling calculation comprising multiple iterations,
   wherein the electrical model and the thermal model are updated for at least some of the iterations based on the current state of health.

13. The computer-implemented method of any one of claims 10 to 12,
wherein the predetermined model comprises an ageing proportionality coefficient that describes the impact of multiple stress factors on the state of health.

14. The computer-implemented method of any one of the preceding claims,

wherein the predetermined model comprises an ageing factor defining an impact of the initial internal pressure on a degradation of the state of health over the lifetime,
wherein the ageing factor optionally defines a function that describes an exponential dependency of the state of health on an internal pressure of the battery cell relative to the initial internal pressure and normalized with respect to a pressure fluctuation due to charging and discharging of the battery cell.

15. The computer-implemented method of any one of claims 10 to 14,
wherein the model is determined based on the method of any one of claims 7 to 9.

# FIG. 1

CLAMP CELL AT CURRENT INITIAL PRESSURE — 3005

CYCLIC AND/OR CALENDRIC AGEING — 3006

MONITOR CAPACITY AND/OR IMPEDANCE — 3010

MONITOR PRESSURE CHANGE — 3015

FURTHER INITIAL PRESSURE? — 3020

YES — 3021

NO

DETERMINE PRESSURE AGEING FACTOR — 3025

DETERMINE ONE OR MORE AGEING FACTORS TO BUILD FORECAST MODEL — 3030

PREDICT SOH-C OR SOH-R — 3035

# FIG. 2

# FIG. 3

Remaining Capacity / SoH-C

$P_1$

$P_2$

$P_3$

Cycles $n$
Time $t$
Charge throughput $Ah$

# FIG. 4

Resistance growth / SoH-R

$P_1$

$P_2$

$P_3$

Cycles $n$
Time $t$
Charge throughput $Ah$

# FIG. 5

# FIG. 6

# FIG. 7

3121

3105

3115

3120

**Initial Pressure and pressure change and pressure fluctuation As a defined values**

Electrical/ Thermal model
↓
Empirical model

*Capacity fade SoHC*

*Resistance/Impedance increase SoHR*

**T, SoC, DoD, C-Rate** From application

3110

# FIG. 8

CPU

MEM

293 291 292

IF

290

# FIG. 9

3105

OBTAIN MODEL

3110

PREDICT SOH-C OR SOH-R

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/160302 A1 (XU JEFF QIANG [US] ET AL) 11 June 2015 (2015-06-11)<br>* paragraphs [0018] – [0043] *<br>----- | 1-15 | INV.<br>H01M10/48<br>H01M50/569<br>H01M10/42<br>G01R31/36 |
| X | WO 2017/087807 A1 (UNIV MICHIGAN REGENTS [US]) 26 May 2017 (2017-05-26)<br>* example 1 *<br>* paragraphs [0028], [0058] – [0060] *<br>* figure 1 *<br>----- | 1-15 | |

TECHNICAL FIELDS
SEARCHED      (IPC)

H01M
G01R

The present search report has been drawn up for all claims

| Place of search | Date of completion of the search | Examiner |
|---|---|---|
| Munich | 3 August 2023 | Mercedes González |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
........................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 23 15 6524

This annex lists the patent family members relating to the patent documents cited in the above-mentioned European search report.
The members are as contained in the European Patent Office EDP file on
The European Patent Office is in no way liable for these particulars which are merely given for the purpose of information.

03-08-2023

| Patent document cited in search report | | Publication date | Patent family member(s) | | Publication date |
|---|---|---|---|---|---|
| US 2015160302 | A1 | 11-06-2015 | NONE | | |
| WO 2017087807 | A1 | 26-05-2017 | EP | 3377363 A1 | 26-09-2018 |
| | | | KR | 20180099668 A | 05-09-2018 |
| | | | US | 2021197691 A1 | 01-07-2021 |
| | | | WO | 2017087807 A1 | 26-05-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102021105784 A1

- US 20220374568 A1

**Non-patent literature cited in the description**

- **CANNARELLA, JOHN ; CRAIG B. ARNOLD.** Stress evolution and capacity fade in constrained lithium-ion pouch cells. *Journal of Power Sources,* 2014, vol. 245, 745-751
- **ROHR, STEPHAN et al.** Quantifying uncertainties in reusing lithium-ion batteries from electric vehicles. *Procedia Manufacturing,* 2017, vol. 8, 603-610

- Cloud-connected battery management for decision making on second-life of electric vehicle batteries. **BAUMANN, MICHAEL ; STEPHAN ROHR ; MARKUS LIENKAMP.** 2018 Thirteenth International Conference on Ecological Vehicles and Renewable Energies (EVER). IEEE, 2018